# EUROPEAN PATENT APPLICATION

(11) **EP 2 192 620 A1**
(43) Date of publication of application: **02.06.2010**
(21) Application number: 07807455.6
(22) Date of filing: 18.09.2007
(51) Int. Cl.: H01L 31/042, C23C 14/08, H01B 5/14, H01B 13/00

(54) **PHOTOELECTRIC CONVERSION APPARATUS AND METHOD FOR MANUFACTURING THE SAME**

(71) Applicant: Mitsubishi Heavy Industries, Ltd., Tokyo 108-8215 (JP)
(72) Inventor: YAMASHITA, Nobuki, Yokohama-shi Kanagawa 236-8515 (JP); WATANABE, Toshiya, Yokohama-shi Kanagawa 236-8515 (JP); SAKAI, Satoshi, Yokohama-shi Kanagawa 236-8515 (JP); NAKANO, Youji, Yokohama-shi Kanagawa 236-8515 (JP)
(74) Representative: Henkel, Feiler & Hänzel
(86) International application number: PCT/JP2007/068054
(87) International publication number: WO 2009/037734

(57) **Abstract**

An object of the present invention is to provide a photovoltaic device and a process for producing such a photovoltaic device that enable a stable, high photovoltaic conversion efficiency to be achieved by using a transparent electrode having an optimal relationship between the resistivity and the transmittance. At least one transparent electrode (12, 16) is either a ZnO layer containing no Ga or a Ga-doped ZnO layer in which the quantity of added Ga is not more than 5 atomic % relative to the Zn within the ZnO layer, and the ZnO layer is formed by a sputtering method using a rare gas containing added oxygen as the sputtering gas, wherein the quantity of oxygen added to the sputtering gas is not less than 0.1% by volume and not more than 5% by volume relative to the combined volume of the oxygen and the rare gas.

## Description

### TECHNICAL FIELD

The present invention relates to a photovoltaic device having a transparent electrode comprising mainly ZnO (zinc oxide), and a process for producing the photovoltaic device.

### BACKGROUND ART

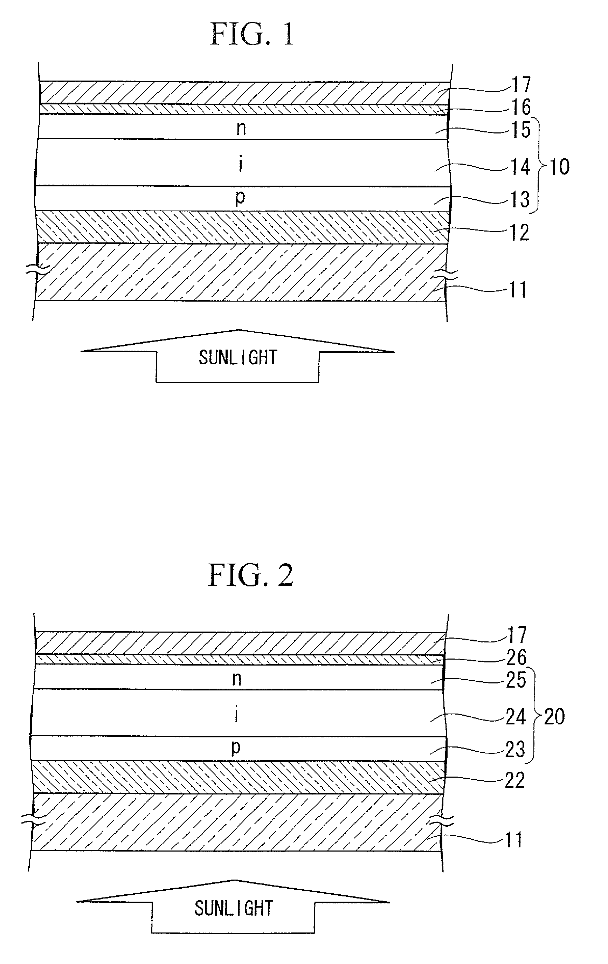

Conventional photovoltaic devices such as solar cells include silicon-based thin-film photovoltaic devices. These photovoltaic devices generally comprise a first transparent electrode, silicon-based semiconductor layers (photovoltaic layers), a second transparent electrode, and a metal electrode film laminated sequentially on top of a substrate.
These transparent electrodes should be made of materials having low resistance and high light transmittance, and oxide-based transparent conductive films such as ZnO (zinc oxide), SnO₂ (tin oxide), and ITO (indium-tin composite oxide) are used. In order to achieve a low resistance for this type of transparent electrode, gallium oxide, aluminum oxide, or fluorine or the like is added to the above transparent electrode material.
Furthermore, in those cases where thin films of amorphous silicon are used for the photovoltaic layers, a technique in which Ga is added to a ZnO layer to enable the transparent electrode film formation to be conducted at low temperatures is also known (for example, see Patent Document 1 (paragraphs 0006 and 0014, and Fig. 1)).
Patent Document 1:
   Japanese Unexamined Patent Application, Publication No. Hei 6-338623

However, the addition of gallium oxide or aluminum oxide to produce a low-resistance transparent electrode results in a decrease in the transmittance of the transparent electrode.
In this manner, addition of Ga or Al to an oxide-based transparent conductive film causes opposing effects on the resistivity and the transmittance, and achieving a combination of favorable resistivity and favorable transmittance is difficult.
Furthermore, Patent Document 1 discloses data showing that, in a solar cell that uses amorphous silicon for the photovoltaic layers, the addition of 0.5 atomic % of Ga relative to Zn in a transparent conductive film comprising mainly ZnO results in increased photovoltaic conversion efficiency compared with the case in which no Ga is added (Example 4 to Example 6 in Table 2), but this technique is merely an investigation of the quantity of added Ga required to enable the formation of the transparent conductive film to be conducted at lower temperatures. In other words, the above technique does not examine the quantity of added Ga required to increase the photovoltaic conversion efficiency by focusing on how the addition of Ga affects either the properties at the interface between the photovoltaic layer and the transparent electrode formed from Ga-doped ZnO, or the resistivity and transmittance of the Ga-doped ZnO layer. Accordingly, a transparent electrode that is optimized to enable further increases in the photovoltaic conversion efficiency is still keenly sought.

### DISCLOSURE OF INVENTION

The present invention was made in light of the above circumstances, and has an object of providing a photovoltaic device which, for a range in which the properties at the interface between a photovoltaic layer and a transparent electrode comprising Ga-doped Zn are not degraded by the addition of Ga, achieves a stable, high photovoltaic conversion efficiency by using a transparent electrode having an optimal relationship between the resistivity and the transmittance, and also providing a process for producing such a photovoltaic device.

In order to achieve the above object, a photovoltaic device of the present invention adopts the aspects described below.
Namely, a photovoltaic device according to the present invention comprises at least a first transparent electrode, a first photovoltaic layer containing mainly amorphous silicon or microcrystalline silicon, and a second transparent electrode laminated sequentially on top of an electrically insulating substrate, wherein at least one of the first transparent electrode and the second transparent electrode is either a ZnO layer containing no Ga, or a Ga-doped ZnO layer in which the quantity of added Ga is not more than 5 atomic % relative to the Zn within the ZnO layer, the ZnO layer is formed by a sputtering method using a rare gas containing added oxygen as the sputtering gas, and the quantity of oxygen added to the sputtering gas is not less than 0.1% by volume and not more than 5% by volume relative to the combined volume of the oxygen and the rare gas.

Furthermore, a process for producing a photovoltaic device according to the present invention is a process for producing a photovoltaic device comprising at least a first transparent electrode, a first photovoltaic layer containing mainly amorphous silicon or microcrystalline silicon, and a second transparent electrode laminated sequentially on top of an electrically insulating substrate, wherein the process comprises a step of forming at least one of the first transparent electrode and the second transparent electrode by a sputtering method that uses a target containing mainly ZnO and a rare gas containing added oxygen as the sputtering gas, the target is either a target containing no Ga, or a Ga-doped target in which the quantity of added Ga is not more than 5 atomic % relative to the Zn within the ZnO, and the quantity of oxygen added to the sputtering gas is not less than 0.1% by volume and not more than 5% by volume relative to the combined volume of the oxygen and the rare gas.

The photovoltaic device according to the present invention may be either a superstrate photovoltaic device in which incident light enters from the side of the electrically insulating substrate, or a substrate photovoltaic device in which incident light enters from the opposite side of the device to the electrically insulating substrate. In the case of a superstrate photovoltaic device, the above electrically insulating substrate must be a transparent electrically insulating substrate, and a back electrode is formed on the second transparent electrode on the opposite side to the photovoltaic layer. Furthermore, in the case of a substrate photovoltaic device, the electrically insulating substrate may be either a non-transparent electrically insulating substrate or a transparent electrically insulating substrate, and the back electrode is formed between this electrically insulating substrate and the first transparent electrode.
In the present invention, the first photovoltaic layer contains mainly amorphous silicon or microcrystalline silicon. The first photovoltaic layer may have either a PIN structure or a NIP structure, made up of a p-type silicon layer, an i-type silicon layer, and an n-type silicon layer.

Adding Ga (gallium) oxide to the ZnO (zinc oxide) layer used as a transparent electrode causes the conductivity to increase, but the transmittance to decrease. As a result of intensive investigation, the inventors of the present invention have discovered that if due consideration is given to use of the transparent electrode within a photovoltaic device, then by maintaining the resistivity at a predetermined level (for example, several Ω·cm) without a great decrease in the transmittance, the photovoltaic conversion efficiency undergoes almost no reduction. In other words, reducing the quantity of Ga within this range in which the conversion efficiency suffers no reduction can be expected to cause an increase in the conversion efficiency due to an increase in the transmittance resulting from the decrease in the quantity of Ga. As a result of further investigation based on this finding, the inventors discovered that in the case of a single photovoltaic device according to the present invention, comprising a single amorphous silicon layer or single microcrystalline silicon layer as the photovoltaic layer, the photovoltaic conversion efficiency could be increased by ensuring that the quantity of added Ga is not more than 5 atomic % relative to the quantity of Zn. Moreover, they also discovered that the photovoltaic conversion efficiency could be increased by forming the Ga-doped ZnO layer by a sputtering method in which Ga-doped ZnO is used as the target, and oxygen is added to the argon of the sputtering gas in a quantity of not less than 0.1% by volume and not more than 5% by volume relative to the combined volume of the argon and oxygen within the sputtering gas. The above target may be either a target containing no Ga, or a Ga-doped target in which the quantity of added Ga is not more than 5 atomic % relative to the Zn within the ZnO.

In the present invention, a physical vapor deposition method may also be employed instead of the above sputtering method. In such a case, the ZnO layer is formed by a physical vapor deposition method using a rare gas containing added oxygen as the reactive gas, wherein the quantity of oxygen added to the reactive gas is typically not less than 0.1% by volume and not more than 5% by volume, and is preferably not less than 1% by volume and not more than 3% by volume, relative to the combined volume of the oxygen and the rare gas. Furthermore, either a vapor deposition material containing no Ga, or a vapor deposition material containing added Ga in which the quantity of Ga is not more than 5 atomic % relative to the Zn within the above ZnO layer can be used.

Because the ZnO layer also has the effect of raising reflectance, the Ga-doped ZnO layer is preferably used for the transparent electrode amongst the first transparent electrode and second transparent electrode that is positioned adjacent to the back electrode.

As described above, in the present invention, the quantity of added Ga is not more than 5 atomic % relative to Zn, and in those cases where the efficiency increases, Ga need not be added (namely, the Ga content may be 0 atomic %). However, the quantity of added Ga is preferably not less than 0.02 atomic % and not more than 2 atomic %, and is even more preferably not less than 0.7 atomic % and not more than 1.7 atomic %. In this description, for the sake of simplicity, ZnO containing not more than a predetermined quantity of added Ga relative to the Zn is referred to as "Ga-doped Zn", even in those cases where the ZnO contains no Ga.

The photovoltaic device according to the present invention may also be a tandem photovoltaic device in which the aforementioned first photovoltaic layer contains mainly microcrystalline silicone, and a second photovoltaic layer containing mainly amorphous silicon is provided between this first photovoltaic layer and the aforementioned first transparent electrode.
Furthermore, the process for producing a photovoltaic device according to the present invention may be a production process in which the aforementioned first photovoltaic layer contains mainly microcrystalline silicone, wherein the process comprises a step of forming a second photovoltaic layer containing mainly amorphous silicon between the first photovoltaic layer and the aforementioned first transparent electrode.

In this type of tandem photovoltaic device, in a similar manner to that described above, adding Ga (gallium) to the ZnO (zinc oxide) layer used as the transparent electrode causes the conductivity to increase, but the transmittance to decrease. As a result of intensive investigation, the inventors of the present invention have discovered that if due consideration is given to use of the transparent electrode within a photovoltaic device, then by maintaining the resistivity at a predetermined level (for example, several Ω·cm) without a great decrease in the resistivity, the photovoltaic conversion efficiency undergoes almost no reduction. In other words, reducing the quantity of Ga within this range in which the conversion efficiency suffers no reduction can be expected to cause an increase in the conversion efficiency due to an increase in the transmittance resulting from the decrease in the quantity of Ga. Moreover, this increase in the conversion efficiency is enhanced by adding oxygen to the atmosphere during sputtering. As a result of further investigation based on this finding, the inventors discovered that in the case of a tandem photovoltaic device according to the present invention, comprising a microcrystalline silicon layer (a first photovoltaic layer) and an amorphous silicon layer (a second photovoltaic layer) as the two photovoltaic layers, the photovoltaic conversion efficiency could be increased by ensuring that the quantity of added Ga is not more than 5 atomic % relative to the quantity of Zn. Moreover, they also discovered that the photovoltaic conversion efficiency could be increased by forming the Ga-doped ZnO layer by a sputtering method in which Ga-doped ZnO is used as the target, and oxygen is added to the argon of the sputtering gas in a quantity of not less than 0.1% by volume and not more than 5% by volume relative to the combined volume of argon and oxygen within the sputtering gas.

In the above tandem photovoltaic device according to the present invention, in a similar manner to that described above, a physical vapor deposition method may be employed instead of the above sputtering method. In such a case, the ZnO layer is formed by a physical vapor deposition method using a rare gas containing added oxygen as the reactive gas, wherein the quantity of oxygen added to the reactive gas is typically not less than 0.1% by volume and not more than 5% by volume, and is preferably not less than 1% by volume and not more than 3% by volume, relative to the combined volume of the oxygen and the rare gas.
Because the ZnO layer also has the effect of raising reflectance, in the tandem photovoltaic device according to the present invention, a Ga-doped ZnO layer is preferably used for the second transparent electrode positioned adjacent to the back electrode, or for the first transparent electrode positioned adjacent to a non-transparent electrically insulating substrate.

In the present invention described above, the rare gas used within either the sputtering gas used in the sputtering method or the reactive gas used in the physical vapor deposition method can use argon, neon, krypton or xenon or the like, although the use of argon is particularly favorable.

According to the present invention, because the quantity of added Ga is reduced as far as possible within a range that enables the desired photovoltaic conversion efficiency to be maintained, with some allowance for an increase in the resistivity of the transparent electrode, reductions in the transmittance caused by the Ga addition can be suppressed, enabling the production of a transparent electrode with high transmittance over a wide range of wavelengths.
Because a high transmittance is achieved in this manner, more intense light can be supplied to the photovoltaic layers, thereby increasing the short-circuit current density, and as a result, increasing the photovoltaic conversion efficiency.
Furthermore, suppressing the quantity of added Ga enhances the properties at the interface with the n-type silicon layer, enabling a high open-circuit voltage, a favorable short-circuit current density and a favorable fill factor to be achieved, and as a result, the photovoltaic conversion efficiency improves.

Furthermore, according to the present invention, by adding a predetermined quantity of oxygen during the formation of the transparent electrode that contains Ga-doped ZnO, either to the sputtering gas used in the sputtering method, or to the reactive gas used in the physical deposition method, the partial pressure of water vapor inside the transparent electrode film formation device, which has an adverse effect on ZnO oxidation, is reduced by a comparative amount, and as a result, the transmittance of the transparent electrode containing the Ga-doped ZnO is stabilized, meaning the photovoltaic conversion efficiency of the final photovoltaic device is also stabilized.

### BRIEF DESCRIPTION OF DRAWINGS

[Fig. 1] A cross-sectional view showing a schematic representation of a single photovoltaic device according to a first embodiment of the present invention, which includes an amorphous silicon photovoltaic layer in which incident light enters from the side of a transparent electrically insulating substrate.
[Fig. 2] A cross-sectional view showing a schematic representation of a single photovoltaic device according to a second embodiment of the present invention, which includes a microcrystalline silicon photovoltaic layer in which incident light enters from the side of a transparent electrically insulating substrate.

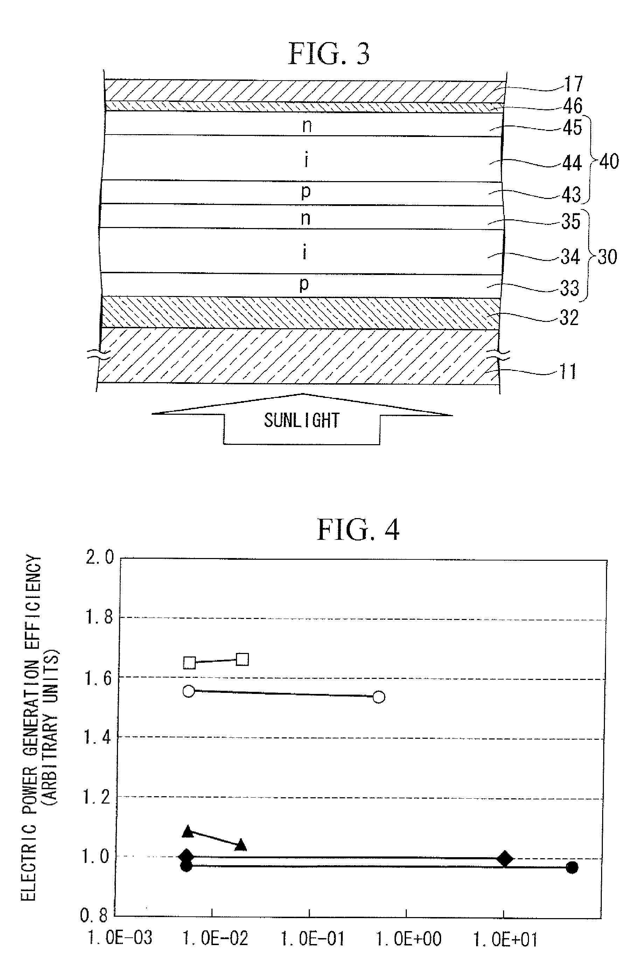

[Fig. 3] A cross-sectional view showing a schematic representation of a tandem photovoltaic device according to a third embodiment of the present invention, which includes an amorphous silicon photovoltaic layer and a microcrystalline silicon photovoltaic layer, and in which incident light enters from the side of a transparent electrically insulating substrate.
[Fig. 4] A graph showing the conversion efficiency of photovoltaic devices relative to the resistivity of the transparent electrode.

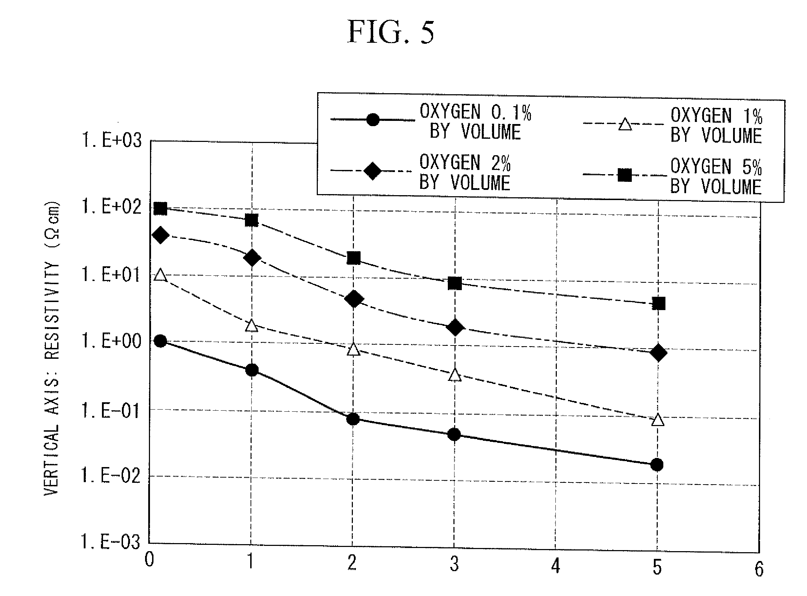

[Fig. 5] A graph showing the resistivity for Ga-doped ZnO layers formed using a sputtering method, for different quantities of added Ga and different quantities of oxygen within the sputtering gas.

### Explanation of Reference Signs:

- 11:: Transparent electrically insulating substrate
- 17:: Back electrode
- 12,22,32:: First transparent electrode
- 16,26,46:: Second transparent electrode
- 10,30:: Amorphous silicon photovoltaic layer
- 20,40:: Microcrystalline silicon photovoltaic layer

### BEST MODE FOR CARRYING OUT THE INVENTION

Embodiments according to the present invention are described below with reference to the drawings.

### First Embodiment

A photovoltaic device according to a first embodiment of the present invention is described below with reference to Fig. 1.
The photovoltaic device according to this embodiment has a photovoltaic layer 10 of amorphous silicon, and incident light enters from the transparent electrically insulating substrate (also referred to as a superstrate device).

### (First Step)

A first transparent electrode 12 is formed on a transparent electrically insulating substrate 11. Optically transparent white crown glass, for example, can be used for the transparent electrically insulating substrate 11.
The first transparent electrode 12 is formed using SnO₂ (tin oxide).
The transparent electrically insulating substrate 11 is housed inside a normal pressure heated CVD apparatus, and a film of SnO₂ is formed on the transparent electrically insulating substrate 11 using SnCl₄, water vapor (H₂O) and anhydrous hydrogen fluoride (HF) as the raw material gases.

### (Second Step)

Subsequently, with the transparent electrically insulating substrate 11 on which the first transparent electrode 12 has been formed held as a processing object at the anode of a plasma enhanced CVD apparatus, the processing object is housed in a reaction chamber, and a vacuum pump is then activated and used to evacuate the interior of the reaction chamber to a vacuum. Subsequently, electricity is supplied to a heater incorporated within the anode, and the substrate of the processing object is heated, for example to 160°C or higher. SiH₄, H₂, and a p-type dopant gas, which function as the raw material gases, are then introduced into the reaction chamber, and the pressure inside the reaction chamber is regulated at a predetermined level. A plasma is then generated between a discharge electrode and the processing object by supplying RF electrical power from an RF power supply to the discharge electrode, thereby forming an amorphous p-type silicon layer 13 on the first transparent electrode 12 of the processing object.
B₂H₆ or the like can be used as the p-type dopant gas.

### (Third Step)

Once the p-type silicon layer 13 has been formed, the transparent electrically insulating substrate 11 is housed inside the reaction chamber of another plasma enhanced CVD apparatus, and the interior of the reaction chamber is evacuated to a vacuum. A mixed gas of SiH₄ and H₂ that functions as the raw material gas is then introduced into the reaction chamber, and the pressure inside the reaction chamber is regulated at a predetermined level. A plasma is then generated between a discharge electrode and the processing object by supplying very high frequency electrical power with a frequency of 60 MHz or higher from a very high frequency power supply to the discharge electrode, thereby forming an amorphous i-type silicon layer 14 on the p-type silicon layer 13 of the processing object.
Furthermore, the pressure during generation of the plasma inside the reaction chamber is preferably set to a value within a range from not less than 0.5 Torr to not more than 10 Torr, and even more preferably to a value within a range from not less than 0.5 Torr to not more than 6.0 Torr.

### (Fourth Step)

Once the i-type silicon layer 14 has been formed, supply of the raw material gas is halted, and the interior of the reaction chamber is evacuated to a vacuum. Subsequently, the transparent electrically insulating substrate 11 is housed inside another reaction chamber that has been evacuated to a vacuum, and SiH₄, H₂, and an n-type dopant gas (such as PH₃), which function as the raw material gases, are introduced into this reaction chamber, and the pressure inside the reaction chamber is regulated at a predetermined level. A plasma is then generated between a discharge electrode and the processing object by supplying very high frequency electrical power from a very high frequency power supply to the discharge electrode, thereby forming an amorphous n-type silicon layer 15 on the i-type silicon layer 14. The processing object is then removed from the plasma enhanced CVD apparatus.
In this manner, by executing the second to fourth steps, an amorphous silicon photovoltaic layer 10 comprising the p-type silicon layer 13, the i-type silicon layer 14, and the n-type silicon layer 15 is formed.

### (Fifth Step)

Once the n-type silicon layer 15 has been formed, supply of the raw material gases is halted, and the interior of the reaction chamber is evacuated to a vacuum. Subsequently, the transparent electrically insulating substrate 11 with the layers up to and including the n-type silicon layer 15 formed thereon is housed inside a direct current sputtering (DC sputtering) apparatus.
In this DC sputtering apparatus, a Ga-doped ZnO layer is formed as a second transparent electrode 16 on the n-type silicon layer 15.
Once the transparent electrically insulating substrate 11 has been housed inside the DC sputtering apparatus, DC sputtering is conducted within an evacuated atmosphere into which a predetermined quantity of a mixed gas of argon gas and oxygen gas has been introduced, thereby forming the Ga-doped ZnO layer on the n-type silicon layer 15. The quantity of added Ga relative to Zn is not more than 5 atomic %, is preferably not less than 0.02 atomic % and not more than 2 atomic %, and is even more preferably not less than 0.7 atomic % and not more than 1.7 atomic %. Furthermore, the quantity of added oxygen relative to the combined volume of argon and oxygen within the sputtering gas is set to a value of not less than 0.1% by volume and not more than 5% by volume.
The pressure inside the DC sputtering apparatus is preferably approximately 0.6 Pa, the temperature of the transparent electrically insulating substrate 11 is preferably not less than 80°C and not more than 135°C, and the sputtering power is preferably approximately 100 W.

Adding Ga to a transparent electrode formed from ZnO causes the conductivity to increase, but the transmittance to decrease. As a result of intensive investigation, the inventors of the present invention discovered that if due consideration is given to use of the transparent electrode within a photovoltaic device, then by maintaining the resistivity at a predetermined level (for example, several _{Ω·}cm) without a great decrease in the resistivity, the photovoltaic conversion efficiency increases.
Fig. 4 shows the relationship between the resistivity of a transparent electrode formed from Ga-doped ZnO (horizontal axis) and the conversion efficiency of a photovoltaic device (vertical axis). In the graph of Fig. 4, the top two lines represent data for tandem photovoltaic devices with different thickness values for the i-layer, the third line from the top represents data for a single photovoltaic device having an amorphous silicon photovoltaic layer, and the bottom two lines represent data for single photovoltaic devices having a microcrystalline silicon photovoltaic layer with different thickness values for the i-layer. From Fig. 4 it is evident that even if the resistivity of the transparent electrode is raised to approximately 50 Ω·cm, the photovoltaic conversion efficiency does not decrease. Accordingly, if the quantity of added Ga is reduced within this range for which the photovoltaic conversion efficiency does not decrease, then the conversion efficiency can be expected to increase due to an increase in the transmittance resulting from the reduction in the quantity of added Ga. Furthermore, by adding oxygen to the argon of the sputtering gas, the transmittance can be increased even further. Moreover, the reduction in the quantity of Ga also improves the properties at the interface between the n-layer and the Ga-doped ZnO.

In this embodiment, as a result of further investigation on the quantity of added Ga based on the above findings, the quantity of Ga added relative to the Zn with the second transparent electrode 16 is restricted to not more than 5 atomic % in the case of a single photovoltaic device comprising a single amorphous silicon photovoltaic layer 10 according to the present embodiment. Furthermore, oxygen is added to the sputtering gas in a quantity of not less than 0.1% by volume and not more than 5% by volume relative to the combined volume of argon and oxygen within the sputtering gas. The inventors discovered that provided the above conditions were satisfied, the photovoltaic conversion efficiency could be increased.
Fig. 5 is a graph showing the resistivity for a transparent electrode under a variety of conditions in which the quantity of oxygen relative to the combined volume of argon and oxygen within the sputtering gas is varied between 0.1% by volume, 1% by volume, 2% by volume and 5% by volume, and the quantity of added Ga relative to Zn within the Ga-doped ZnO transparent electrode is varied within the range specified by the present invention.

In the case where a physical vapor deposition method is conducted instead of the sputtering method, a rare gas containing added oxygen is used as the reactive gas, and the quantity of oxygen added is not less than 0.1% by volume and not more than 5% by volume relative to the combined volume of argon and oxygen within the reactive gas.

### (Sixth Step)

Subsequently, an Ag film or Al film is formed as a back electrode 17 on the second transparent electrode 16. A photovoltaic device produced in this manner generates electricity by photovoltaic conversion from incident light such as sunlight that enters the amorphous silicon layer with the PIN structure described above via the transparent electrically insulating substrate 11.

In the production of the photovoltaic device, the photovoltaic layer 10 was formed with a PIN structure by sequential formation of the p-type silicon layer 13, the i-type silicon layer 14, and the n-type silicon layer 15 on top of the first transparent electrode 12, but the photovoltaic layer 10 may also be formed with a NIP structure by sequential formation of an n-type silicon layer, i-type silicon layer, and p-type silicon layer.

Furthermore, in this embodiment, the ZnO layer in which the quantity of added Ga relative to Zn was restricted to not more than 5 atomic % and the quantity of oxygen added was restricted to not more than 5% by volume was used for the second transparent electrode 16, but the present invention is not limited to this case, and the above ZnO layer may also be used for the first transparent electrode 12.
However, because the transparent electrode also has the effect of increasing the reflectance, the Ga-doped ZnO layer of the present invention is preferably employed as the second transparent electrode 16 positioned adjacent to the back electrode 17.

According to this embodiment, Ga-doped ZnO was employed as the second transparent electrode 16, the quantity of added Ga relative to Zn was restricted to not more than 5 atomic %, the quantity of oxygen added to the sputtering gas during formation of the Ga-doped ZnO was set to a value of not less than 0.1% by volume and not more than 5% by volume relative to the combined volume of argon and oxygen within the sputtering gas, and the quantity of added Ga was reduced as far as possible within a range that enabled the desired photovoltaic conversion efficiency to be maintained, with some allowance for an increase in the resistivity of the second transparent electrode 16, and as a result, reductions in the transmittance were suppressed, enabling the production of a second transparent electrode 16 with high transmittance over a wide range of wavelengths. Furthermore, by adding oxygen to the film formation atmosphere, a more stable production that is unaffected by outgas from the vacuum chamber can be achieved.
Because a high transmittance is achieved in this manner, more intense light can be supplied to the photovoltaic layer 10, thereby increasing the short-circuit current density, and as a result, increasing the photovoltaic conversion efficiency.

### Second Embodiment

A photovoltaic device according to a second embodiment of the present invention is described below with reference to Fig. 2.
The photovoltaic device according to this embodiment has a photovoltaic layer 20 of microcrystalline silicon, and incident light enters from the transparent electrically insulating substrate. Although the photovoltaic device according to this embodiment has an electricity-generating layer made of microcrystalline silicon, the incident light enters from the transparent electrically insulating substrate in the same manner as the first embodiment (namely, a superstrate device).

### (First Step)

A first transparent electrode 22 is formed on a transparent electrically insulating substrate 11. Optically transparent white crown glass, for example, can be used for the transparent electrically insulating substrate 11.
The first transparent electrode 22 is formed using SnO₂ (tin oxide).
The transparent electrically insulating substrate 11 is housed inside a normal pressure heated CVD apparatus, and a film of SnO₂ is formed on the transparent electrically insulating substrate 11 using SnCl₄, water vapor (H₂O) and anhydrous hydrogen fluoride (HF) as the raw material gases.

### (Second Step)

Subsequently, with the transparent electrically insulating substrate 11 on which the first transparent electrode 22 has been formed held as a processing object at the anode of a plasma enhanced CVD apparatus, the processing object is housed in a reaction chamber, and a vacuum pump is then activated and used to evacuate the interior of the reaction chamber to a vacuum. Subsequently, electricity is supplied to a heater incorporated within the anode, and the substrate of the processing object is heated, for example to 160°C or higher. SiH₄, H₂, and a p-type dopant gas, which function as the raw material gases, are then introduced into the reaction chamber, and the pressure inside the reaction chamber is regulated at a predetermined level. A plasma is then generated between a discharge electrode and the processing object by supplying very high frequency electrical power from a very high frequency power supply to the discharge electrode, thereby forming a microcrystalline p-type silicon layer 23 on the first transparent electrode 22 of the processing object.
B₂H₆ or the like can be used as the p-type dopant gas.

### (Third Step)

Once the p-type silicon layer 23 has been formed, the transparent electrically insulating substrate 11 is housed inside the reaction chamber of another plasma enhanced CVD apparatus, and the interior of the reaction chamber is evacuated to a vacuum. A mixed gas of SiH₄ and H₂ that functions as the raw material gas is then introduced into the reaction chamber, and the pressure inside the reaction chamber is regulated at a predetermined level. A plasma is then generated between a discharge electrode and the processing object by supplying very high frequency electrical power with a frequency of 60 MHz or higher from a very high frequency power supply to the discharge electrode, thereby forming a microcrystalline i-type silicon layer 24 on the p-type silicon layer 23 of the processing object.

Furthermore, the pressure during generation of the plasma inside the reaction chamber is preferably set to a value within a range from not less than 0.5 Torr to not more than 10 Torr, and even more preferably to a value within a range from not less than 1.0 Torr to not more than 6.0 Torr.

### (Fourth Step)

Once the i-type silicon layer 24 has been formed, supply of the raw material gas is halted, and the interior of the reaction chamber is evacuated to a vacuum. Subsequently, the transparent electrically insulating substrate 11 is housed inside another reaction chamber that has been evacuated to a vacuum, and SiH₄, H₂, and an n-type dopant gas (such as PH₃), which function as the raw material gases, are introduced into this reaction chamber, and the pressure inside the reaction chamber is regulated at a predetermined level. A plasma is then generated between a discharge electrode and the processing object by supplying very high frequency electrical power from a very high frequency power supply to the discharge electrode, thereby forming a microcrystalline n-type silicon layer 25 on the i-type silicon layer 24. The processing object is then removed from the plasma enhanced CVD apparatus.
In this manner, by executing the second to fourth steps, a microcrystalline silicon photovoltaic layer 20 comprising the p-type silicon layer 23, the i-type silicon layer 24, and the n-type silicon layer 25 is formed.

### (Fifth Step)

Once the n-type silicon layer 25 has been formed, supply of the raw material gases is halted, and the interior of the reaction chamber is evacuated to a vacuum. Subsequently, the transparent electrically insulating substrate 11 with the layers up to and including the n-type silicon layer 25 formed thereon is housed inside a DC sputtering apparatus.
In this DC sputtering apparatus, a Ga-doped ZnO layer is formed as a second transparent electrode 26 on the n-type silicon layer 25.
Once the transparent electrically insulating substrate 11 has been housed inside the DC sputtering apparatus, DC sputtering is conducted within an evacuated atmosphere into which a predetermined quantity of argon gas has been introduced, thereby forming the Ga-doped ZnO layer on the n-type silicon layer 25. The quantity of added Ga relative to Zn is not more than 5 atomic %, is preferably not less than 0.02 atomic % and not more than 2 atomic %, and is even more preferably not less than 0.7 atomic % and not more than 1.7 atomic %. Furthermore, the quantity of added oxygen relative to the combined volume of argon gas and oxygen within the sputtering gas is set to a value of not less than 0.1% by volume and not more than 5% by volume.
The pressure inside the DC sputtering apparatus is preferably approximately 0.6 Pa, the temperature of the transparent electrically insulating substrate 11 is preferably not less than 80°C and not more than 135°C, and the sputtering power is preferably approximately 100 W.
The reasons that the quantity of added Ga and the quantity of added oxygen were selected in the manner described above are as described above for the first embodiment with reference to Fig. 4. Namely, if the quantity of added Ga is reduced within the range for which the conversion efficiency for the photovoltaic device does not decrease, then the conversion efficiency can be expected to increase due to an increase in the transmittance resulting from the reduction in the quantity of added Ga, and furthermore, if the quantity of added oxygen is increased, then the conversion efficiency can be expected to increase due to an increase in the transmittance. Moreover, the reduction in the quantity of Ga also improves the properties at the interface between the n-layer and the Ga-doped ZnO. In this embodiment, as a result of investigations from the above perspectives of the quantity of added Ga and the quantity of added oxygen, the quantity of Ga added relative to Zn in the second transparent electrode 26 is restricted to not more than 5 atomic % for the case of a single photovoltaic device comprising a single microcrystalline silicon photovoltaic layer 20 according to the present invention. Furthermore, oxygen is added to the sputtering gas in sufficient quantity that the volume of oxygen relative to the combined volume of argon and oxygen within the sputtering gas is not less than 0.1% by volume and not more than 5% by volume. It was discovered that provided these conditions were satisfied, the photovoltaic conversion efficiency could be increased.

### (Sixth Step)

Subsequently, an Ag film or Al film is formed as a back electrode 27 on the second transparent electrode 26 using a sputtering method or vacuum vapor deposition method.

A photovoltaic device produced in this manner generates electricity by photovoltaic conversion from incident light such as sunlight that enters the microcrystalline silicon layer with the PIN structure described above via the transparent electrically insulating substrate 11.

In the production of the photovoltaic device, the photovoltaic layer 20 was formed with a PIN structure by sequential formation of the p-type silicon layer 23, the i-type silicon layer 24, and the n-type silicon layer 25 on top of the first transparent electrode 22, but the photovoltaic layer 20 may also be formed with a NIP structure by sequential formation of an n-type silicon layer i-type silicon layer, and p-type silicon layer.
Furthermore, in this embodiment, the ZnO layer in which the quantity of added Ga relative to Zn was restricted to not more than 5 atomic % was used for the second transparent electrode 26, but the present invention is not limited to this case, and the above ZnO layer may also be used for the first transparent electrode 22.
However, because the transparent electrode also has the effect of increasing the reflectance, the Ga-doped ZnO layer of the present invention is preferably employed as the second transparent electrode 26 positioned adjacent to the back electrode 27.

According to this embodiment, Ga-doped ZnO was employed as the second transparent electrode 26, the quantity of added Ga relative to Zn was restricted to not more than 5 atomic %, the quantity of oxygen added to the sputtering gas during formation of the Ga-doped ZnO layer was set to a value of not less than 0.1% by volume and not more than 5% by volume relative to the combined volume of argon and oxygen within the sputtering gas, and the quantity of added Ga was reduced as far as possible within a range that enabled the desired photovoltaic conversion efficiency to be maintained, with some allowance for an increase in the resistivity of the second transparent electrode 26, and as a result, reductions in the transmittance were suppressed, enabling the production of a second transparent electrode 26 with high transmittance over a wide range of wavelengths. Furthermore, by adding oxygen to the film formation atmosphere, a more stable production that is unaffected by outgas from the vacuum chamber can be achieved.
Because a high transmittance is achieved in this manner, more intense light can be supplied to the photovoltaic layer 20, thereby increasing the short-circuit current density, and as a result, increasing the photovoltaic conversion efficiency.
Furthermore, suppressing the quantity of added Ga enhances the interface properties with the p-type and n-type silicon layers, enabling a high open-circuit voltage, a favorable short-circuit current density and a favorable fill factor to be achieved, and as a result, the photovoltaic conversion efficiency improves.

### Third Embodiment

A photovoltaic device according to a third embodiment of the present invention is described below with reference to Fig. 3.
The photovoltaic device according to this embodiment differs from each of the above embodiments in that it is a tandem device in which the photovoltaic layer comprises an amorphous silicon photovoltaic layer 30 (a second photovoltaic layer) and a microcrystalline silicon photovoltaic layer 40 (a first photovoltaic layer) laminated together. The photovoltaic device according to this embodiment is similar to the first embodiment and second embodiment in that the incident light enters from the transparent electrically insulating substrate (namely, a superstrate devices).

### (First Step)

A first transparent electrode 32 is formed on a transparent electrically insulating substrate 11. Optically transparent white crown glass, for example, can be used for the transparent electrically insulating substrate 11.
The first transparent electrode 32 is formed using SnO₂ (tin oxide).
The transparent electrically insulating substrate 11 is housed inside a normal pressure heated CVD apparatus, and a film of SnO₂ is formed on the transparent electrically insulating substrate 11 using SnCl₄, water vapor (H₂O) and anhydrous hydrogen fluoride (HF) as the raw material gases.

### (Second Step)

Subsequently, with the transparent electrically insulating substrate 11 on which the first transparent electrode 32 has been formed held as a processing object at the anode of a plasma enhanced CVD apparatus, the processing object is housed in a reaction chamber, and a vacuum pump is then activated and used to evacuate the interior of the reaction chamber to a vacuum. Subsequently, electricity is supplied to a heater incorporated within the anode, and the substrate of the processing object is heated, for example to 160°C or higher. SiH₄, H₂, and a p-type dopant gas, which function as the raw material gases, are then introduced into the reaction chamber, and the pressure inside the reaction chamber is regulated at a predetermined level. A plasma is then generated between a discharge electrode and the processing object by supplying RF electrical power from an RF power supply to the discharge electrode, thereby forming an amorphous p-type silicon layer 33 on the first transparent electrode 32 of the processing object. B₂H₆ or the like can be used as the p-type dopant gas.

### (Third Step)

Once the p-type silicon layer 33 has been formed, the transparent electrically insulating substrate 11 is housed inside the reaction chamber of another plasma enhanced CVD apparatus, and the interior of the reaction chamber is evacuated to a vacuum. A mixed gas of SiH₄ and H₂ that functions as the raw material gas is then introduced into the reaction chamber, and the pressure inside the reaction chamber is regulated at a predetermined level. A plasma is then generated between a discharge electrode and the processing object by supplying very high frequency electrical power with a frequency of 60 MHz or higher from a very high frequency power supply to the discharge electrode, thereby forming an amorphous i-type silicon layer 34 on the p-type silicon layer 33 of the processing object.

Furthermore, the pressure during generation of the plasma inside the reaction chamber is preferably set to a value within a range from not less than 0.5 Torr to not more than 10 Torr, and even more preferably to a value within a range from not less than 0.5 Torr to not more than 6.0 Torr.

### (Fourth Step)

Once the i-type silicon layer 34 has been formed, supply of the raw material gas is halted, and the interior of the reaction chamber is evacuated to a vacuum. Subsequently, the transparent electrically insulating substrate 11 is housed inside another reaction chamber that has been evacuated to a vacuum, and SiH₄, H₂, and an n-type dopant gas (such as PH₃), which function as the raw material gases, are introduced into this reaction chamber, and the pressure inside the reaction chamber is regulated at a predetermined level. A plasma is then generated between a discharge electrode and the processing object by supplying very high frequency electrical power from a very high frequency power supply to the discharge electrode, thereby forming an amorphous n-type silicon layer 35 on the i-type silicon layer 34. The processing object is then removed from the plasma enhanced CVD apparatus.
In this manner, by executing the second to fourth steps, an amorphous silicon photovoltaic layer 30 comprising the p-type silicon layer 33, the i-type silicon layer 34, and the n-type silicon layer 35 is formed.

### (Fifth Step)

Next, a microcrystalline silicon photovoltaic layer 40 is formed on top of the above amorphous silicon photovoltaic layer 30.
The method of forming the microcrystalline silicon photovoltaic layer 40 is the same as that described for the second embodiment.
In other words, with the transparent electrically insulating substrate 11 on which the amorphous silicon photovoltaic layer 30 has been formed held as a processing object at the anode of a plasma enhanced CVD apparatus, the processing object is housed in a reaction chamber, and a vacuum pump is then activated and used to evacuate the interior of the reaction chamber to a vacuum. Subsequently, electricity is supplied to a heater incorporated within the anode, and the substrate of the processing object is heated, for example to 160°C or higher. SiH₄, H₂, and a p-type dopant gas, which function as the raw material gases, are then introduced into the reaction chamber, and the pressure inside the reaction chamber is regulated at a predetermined level. A plasma is then generated between a discharge electrode and the processing object by supplying very high frequency electrical power from a very high frequency power supply to the discharge electrode, thereby forming a microcrystalline p-type silicon layer 43 on the amorphous silicon photovoltaic layer 30 of the processing object.
B₂H₆ or the like can be used as the p-type dopant gas.

### (Sixth Step)

Once the p-type silicon layer 43 has been formed, the transparent electrically insulating substrate 11 is housed inside the reaction chamber of another plasma enhanced CVD apparatus, and the interior of the reaction chamber is evacuated to a vacuum. A mixed gas of SiH₄ and H₂ that functions as the raw material gas is then introduced into the reaction chamber, and the pressure inside the reaction chamber is regulated at a predetermined level. A plasma is then generated between a discharge electrode and the processing object by supplying very high frequency electrical power with a frequency of 60 MHz or higher from a very high frequency power supply to the discharge electrode, thereby forming a microcrystalline i-type silicon layer 44 on the p-type silicon layer 43 of the processing object.

Furthermore, the pressure during generation of the plasma inside the reaction chamber is preferably set to a value within a range from not less than 0.5 Torr to not more than 10 Torr, and even more preferably to a value within a range from not less than 1.0 Torr to not more than 6.0 Torr.

### (Seventh Step)

Once the i-type silicon layer 44 has been formed, supply of the raw material gas is halted, and the interior of the reaction chamber is evacuated to a vacuum. Subsequently, the transparent electrically insulating substrate 11 is housed inside another reaction chamber that has been evacuated to a vacuum, and SiH₄, H₂, and an n-type dopant gas (such as PH₃), which function as the raw material gases, are introduced into this reaction chamber, and the pressure inside the reaction chamber is regulated at a predetermined level. A plasma is then generated between a discharge electrode and the processing object by supplying very high frequency electrical power from a very high frequency power supply to the discharge electrode, thereby forming a microcrystalline n-type silicon layer 45 on the i-type silicon layer 44. The processing object is then removed from the plasma enhanced CVD apparatus.
In this manner, by executing the fifth to seventh steps, a microcrystalline silicon photovoltaic layer 40 comprising the p-type silicon layer 43, the i-type silicon layer 44, and the n-type silicon layer 45 is formed.

### (Eighth Step)

Once the n-type silicon layer 45 has been formed, supply of the raw material gases is halted, and the interior of the reaction chamber is evacuated to a vacuum. Subsequently, the transparent electrically insulating substrate 11 with the layers up to and including the n-type silicon layer 45 formed thereon is housed inside a DC sputtering apparatus.
In this DC sputtering apparatus, a Ga-doped ZnO layer is formed as a second transparent electrode 46 on the n-type silicon layer 45.
Once the transparent electrically insulating substrate 11 has been housed inside the DC sputtering apparatus, DC sputtering is conducted within an evacuated atmosphere into which a predetermined quantity of argon gas has been introduced, thereby forming the Ga-doped ZnO layer on the n-type silicon layer 45. The quantity of added Ga relative to Zn is not more than 5 atomic %, is preferably not less than 0.02 atomic % and not more than 2 atomic %, and is even more preferably not less than 0.7 atomic % and not more than 1.7 atomic %. The reasons that the quantity of added Ga is selected from within this numerical range are the same as those described above for the first embodiment, and consequently, an explanation of those reasons is omitted here.
The pressure inside the DC sputtering apparatus is preferably approximately 0.6 Pa, the temperature of the transparent electrically insulating substrate 11 is preferably not less than 80°C and not more than 135°C, and the sputtering power is preferably approximately 100 W.

### (Ninth Step)

Subsequently, an Ag film or Al film is formed as a back electrode 17 on the second transparent electrode 46.
A tandem photovoltaic device produced in this manner generates electricity by photovoltaic conversion from incident light such as sunlight that enters the amorphous silicon photovoltaic layer 30 and the microcrystalline silicon layer 40 with the PIN structures described above via the transparent electrically insulating substrate 11.
In the production of the photovoltaic device, the amorphous silicon photovoltaic layer 30 was formed with a PIN structure by sequential formation of the p-type silicon layer 33, the i-type silicon layer 34, and the n-type silicon layer 35 on top of the first transparent electrode 42, but the photovoltaic layer 30 may also be formed with a NIP structure by sequential formation of an n-type silicon layer i-type silicon layer, and p-type silicon layer.
Furthermore, the microcrystalline silicon photovoltaic layer 40 was formed with a PIN structure by sequential formation of the p-type silicon layer 43, the i-type silicon layer 44, and the n-type silicon layer 45 from the side of the first transparent electrode 42, but the photovoltaic layer 40 may also be formed with a NIP structure by sequential formation of an n-type silicon layer i-type silicon layer, and p-type silicon layer.

Furthermore, in this embodiment, the ZnO layer in which the quantity of added Ga relative to Zn was restricted to not more than 5 atomic % was used for the second transparent electrode 46, but the present invention is not limited to this case, and the above ZnO layer may also be used for the first transparent electrode 32.
However, because the transparent electrode also has the effect of increasing the reflectance, the Ga-doped ZnO layer of the present invention is preferably employed as the second transparent electrode 46 positioned adjacent to the back electrode 17.
According to this embodiment, Ga-doped ZnO was employed as the second transparent electrode 46, the quantity of added Ga relative to Zn was restricted to not more than 5 atomic %, the quantity of oxygen added to the sputtering gas during formation of the Ga-doped ZnO layer was set to a value of not less than 0.1% by volume and not more than 5% by volume relative to the combined volume of argon and oxygen within the sputtering gas, and the quantity of added Ga was reduced as far as possible within a range that enabled the desired photovoltaic conversion efficiency to be maintained, with some allowance for an increase in the resistivity of the second transparent electrode 46, and as a result, reductions in the transmittance caused by the Ga addition were suppressed, enabling the production of a second transparent electrode 46 with high transmittance over a wide range of wavelengths. Accordingly, because there is no longer any necessity to add oxygen during the formation of the ZnO layer in order to improve the transmittance, damage to the transparent electrode caused by oxygen can be reduced, which improves the controllability and yield during film formation.
Because a high transmittance is achieved in this manner, more intense light can be supplied to the photovoltaic layer, thereby increasing the short-circuit current density, and as a result, increasing the photovoltaic conversion efficiency.
Furthermore, suppressing the quantity of added Ga enhances the interface properties with the p-type and n-type silicon layers, enabling a high open-circuit voltage, a favorable short-circuit current density and a favorable fill factor to be achieved, and as a result, the photovoltaic conversion efficiency improves.

In the above first through third embodiments, the descriptions focused on applications of the present invention to superstrate photovoltaic devices, but the present invention is not limited to this configuration, and may also be applied to substrate photovoltaic devices. In such cases, a Ga-doped ZnO layer of the present invention can be used for the transparent electrode on the substrate side, the transparent electrode on the light incident side, or for both of these transparent electrodes.

### EXAMPLES

Examples of the present invention are described below.

### First Test Example

In a first test example, photovoltaic devices of examples 1 to 4 were prepared with the same layer configuration as that of the first embodiment. Specifically, single photovoltaic devices including a single amorphous silicon photovoltaic layer 10 in which incident light enters from the side of the transparent electrically insulating substrate 11 were prepared as shown in Fig. 1.
The first transparent electrode 12 was SnO₂. The quantity of added Ga relative to Zn within the second transparent electrode 16, and the quantity of oxygen added to the sputtering gas used during formation of the Ga-doped ZnO layer, relative to the combined volume of argon and oxygen within the sputtering gas, were set to the values shown in Table 1.
The film thickness of the second transparent electrode 16 was 80 nm.
In each case, the transmittance of the second transparent electrode 16 was 95% or greater within the wavelength region of 550 nm or greater.
As a comparative example 1, a photovoltaic device was prepared in the same manner as the example 1 through example 4, with the exceptions of setting the quantity of added Ga relative to Zn within the ZnO of the second transparent electrode 16 to 6 atomic %, and setting the quantity of oxygen added to the sputtering gas used during formation of the Ga-doped ZnO layer, relative to the combined volume of argon and oxygen within the sputtering gas, to 0% by volume.

### Second Test Example

In a second test example, photovoltaic devices of examples 5 to 8 were prepared with the same layer configuration as that of the second embodiment. Specifically, single photovoltaic devices including a single microcrystalline silicon photovoltaic layer 20 in which incident light enters from the side of the transparent electrically insulating substrate 11 were prepared as shown in Fig. 2.
The first transparent electrode 22 was SnO₂. The quantity of added Ga relative to Zn within the second transparent electrode 26, and the quantity of oxygen added to the sputtering gas used during formation of the Ga-doped ZnO layer, relative to the combined volume of argon and oxygen within the sputtering gas, were set to the values shown in Table 2.
The film thickness of the second transparent electrode 26 was 80 nm.
In each case, the transmittance of the second transparent electrode 26 was 95% or greater within the wavelength region of 550 nm or greater.
As a comparative example 2, a photovoltaic device was prepared in the same manner as the example 5 through example 8, with the exceptions of setting the quantity of added Ga relative to Zn within the ZnO of the second transparent electrode 26 to 6 atomic %, and setting the quantity of oxygen added to the sputtering gas used during formation of the Ga-doped ZnO layer, relative to the combined volume of argon and oxygen within the sputtering gas, to 0% by volume.

### Third Test Example

In a third test example, photovoltaic devices of examples 9 to 12 were prepared with the same layer configuration as that of the third embodiment. Specifically, tandem photovoltaic devices including a single amorphous silicon photovoltaic layer 30 and a single microcrystalline silicon photovoltaic layer 40, in which incident light enters from the side of the transparent electrically insulating substrate 11, were prepared as shown in Fig. 3.
The first transparent electrode 32 was SnO₂ The quantity of added Ga relative to Zn within the second transparent electrode 46, and the quantity of oxygen added to the sputtering gas used during formation of the Ga-doped ZnO layer, relative to the combined volume of argon and oxygen within the sputtering gas, were set to the values shown in Table 3.
The film thickness of the second transparent electrode 46 was 80 nm.
In each case, the transmittance of the second transparent electrode 46 was 95% or greater within the wavelength region of 550 nm or greater.
As a comparative example 3, a photovoltaic device was prepared in the same manner as the example 9 through example 12, with the exceptions of setting the quantity of added Ga relative to Zn within the ZnO of the second transparent electrode 46 to 6 atomic %, and setting the quantity of oxygen added to the sputtering gas used during formation of the Ga-doped ZnO layer, relative to the combined volume of argon and oxygen within the sputtering gas, to 0% by volume.

The electric power generation performance of the photovoltaic devices of the above Examples 1 to 12 and the comparative examples 1 to 3 corresponding with those examples was evaluated by irradiating the transparent electrically insulating substrate 11 of each photovoltaic device with simulated sunlight (spectral type: AM 1.5; irradiation intensity: 100 mW/m²; irradiation temperature: 25°C). The results are shown in Table 1 to Table 3.

**Table 1**

| | First Test Example (a-Si single) | | | | |
|---|---|---|---|---|---|
| | Comparative example 1 | Example 1 | Example 2 | Example 3 | Example 4 |
| Ga (at. %) | 6 | 1 | 1.5 | 5 | 0.05 |
| O₂ (vol. %) | 0 | 1 | 0.1 | 2 | 5 |
| Jsc (short-circuit current density) | 1 | 1.09 | 1.1 | 1.1 | 1.09 |
| Voc (open-circuit voltage) | 1 | 1 | 1 | 1 | 1 |
| FF (fill factor) | 1 | 1 | 1 | 1 | 1 |
| Eff. (conversion efficiency) | 1 | 1.03 | 1.04 | 1.04 | 1.02 |

**Table 2**

| | Second Test Example (microcrystalline Si single) | | | | |
|---|---|---|---|---|---|
| | Comparative example 2 | Example 5 | Example 6 | Example 7 | Example 8 |
| Ga (at. %) | 6 | 1 | 2 | 0.2 | 4 |
| O₂ (vol. %) | 0 | 1.7 | 0.1 | 3 | 5 |
| Jsc (short-circuit current density) | 1 | 1.1 | 1.1 | 1.1 | 1.11 |
| Voc (open-circuit voltage) | 1 | 1 | 1 | 1 | 1 |
| FF (fill factor) | 1 | 1.01 | 1 | 1.01 | 1 |
| Eff. (conversion efficiency) | 1 | 1.08 | 1.07 | 1.08 | 1.08 |

**Table 3**

| | Third Test Example (tandem) | | | | |
|---|---|---|---|---|---|
| | Comparative example 3 | Example 9 | Example 10 | Example 11 | Example 12 |
| Ga (at. %) | 6 | 1 | 1 | 4 | 0.1 |
| O₂ (vol. %) | 0 | 1.5 | 3 | 0.5 | 4 |
| Jsc (short-circuit current density) | 1 | 1.1 | 1.1 | 1.09 | 1.09 |
| Voc (open-circuit voltage) | 1 | 1 | 1 | 1 | 1 |
| FF (fill factor) | 1 | 1.01 | 1.01 | 1 | 1.01 |
| Eff. (conversion efficiency) | 1 | 1.05 | 1.05 | 1.03 | 1.03 |

Table 1 shows the Jsc (short-circuit current density), Voc (open-circuit voltage), FF (fill factor) and Eff. (conversion efficiency) for each example and the comparative example. In each of the test examples, the values for each example are shown as relative values wherein the measured value of the respective comparative example was set to 1.
As is evident from Table 1 to Table 3, reducing the quantity of added Ga relative to Zn within the ZnO of the transparent electrode comprising the Ga-doped ZnO layer, and adding oxygen to the sputtering gas used during formation of the Ga-doped ZnO layer enables high transmittance to be achieved over a wide range of wavelengths, meaning more intense light can be supplied to the photovoltaic layer, thereby increasing the Jsc (short-circuit current density).

Because the Jsc (short-circuit current density) and the FF (fill factor) are improved in this manner, it is evident that reducing the quantity of added Ga within the Ga-doped ZnO transparent electrode yields an increase in the conversion efficiency.
In particular, the microcrystalline silicon single photovoltaic devices of the Test Example 2 exhibit significant improvement in the Eff. (conversion efficiency). It is thought that the reason for this improvement is that the decrease in the quantity of Ga causes an improvement in the properties at the interface between the n-layer and the Ga-doped ZnO layer.

## Claims

1. A photovoltaic device comprising at least a first transparent electrode, a first photovoltaic layer containing mainly amorphous silicon or microcrystalline silicon, and a second transparent electrode laminated sequentially on top of an electrically insulating substrate, wherein
at least one of the first transparent electrode and the second transparent electrode is either a ZnO layer containing no Ga, or a Ga-doped ZnO layer in which a quantity of added Ga is not more than 5 atomic % relative to Zn within the 2nO layer, and
the ZnO layer is formed by a sputtering method using a rare gas containing added oxygen as a sputtering gas, wherein a quantity of oxygen added to the sputtering gas is not less than 0.1% by volume and not more than 5% by volume relative to a combined volume of the oxygen and the rare gas.

2. A photovoltaic device comprising at least a first transparent electrode, a first photovoltaic layer containing mainly amorphous silicon or microcrystalline silicon, and a second transparent electrode laminated sequentially on top of an electrically insulating substrate, wherein
at least one of the first transparent electrode and the second transparent electrode is either a ZnO layer containing no Ga, or a Ga-doped ZnO layer in which a quantity of added Ga is not more than 5 atomic % relative to Zn within the ZnO layer, and
the ZnO layer is formed by a physical vapor deposition method using a rare gas containing added oxygen as a reactive gas, wherein a quantity of oxygen added to the reactive gas is not less than 0.1% by volume and not more than 5% by volume relative to a combined volume of the oxygen and the rare gas.

3. A photovoltaic device according to claim 1, wherein the first photovoltaic layer contains mainly microcrystalline silicon, and a second photovoltaic layer containing mainly amorphous silicon is provided between the first photovoltaic layer and the first transparent electrode.

4. A photovoltaic device according to claim 2, wherein the first photovoltaic layer contains mainly microcrystalline silicon, and a second photovoltaic layer containing mainly amorphous silicon is provided between the first photovoltaic layer and the first transparent electrode.

5. A process for producing a photovoltaic device comprising at least a first transparent electrode, a first photovoltaic layer containing mainly amorphous silicon or microcrystalline silicon, and a second transparent electrode laminated sequentially on top of an electrically insulating substrate, wherein
the process comprises a step of forming at least one of the first transparent electrode and the second transparent electrode by a sputtering method that uses a target containing mainly ZnO, and a rare gas containing added oxygen as a sputtering gas,
the target is either a target containing no Ga, or a Ga-doped target in which a quantity of added Ga is not more than 5 atomic % relative to Zn within the ZnO, and
a quantity of oxygen added to the sputtering gas is not less than 0.1% by volume and not more than 5% by volume relative to a combined volume of the oxygen and the rare gas.

6. A process for producing a photovoltaic device comprising at least a first transparent electrode, a first photovoltaic layer containing mainly amorphous silicon or microcrystalline silicon, and a second transparent electrode laminated sequentially on top of an electrically insulating substrate, wherein
the process comprises a step of forming at least one of the first transparent electrode and the second transparent electrode by a physical vapor deposition method that uses a vapor deposition material containing mainly ZnO, and a rare gas containing added oxygen as a reactive gas,
the vapor deposition material is either a vapor deposition material containing no Ga, or a Ga-doped vapor deposition material in which a quantity of added Ga is not more than 5 atomic % relative to Zn within the ZnO, and
a quantity of oxygen added to the reactive gas is not less than 0.5% by volume and not more than 5% by volume relative to a combined volume of the oxygen and the rare gas.

7. A process for producing a photovoltaic device according to claim 5, wherein the first photovoltaic layer contains mainly microcrystalline silicon, and the process comprises a step of forming a second photovoltaic layer containing mainly amorphous silicon between the first photovoltaic layer and the first transparent electrode.

8. A process for producing a photovoltaic device according to claim 6, wherein the first photovoltaic layer contains mainly microcrystalline silicon, and the process comprises a step of forming a second photovoltaic layer containing mainly amorphous silicon between the first photovoltaic layer and the first transparent electrode.
